# EUROPÄISCHE PATENTSCHRIFT

(11) **EP 1 989 723 B1**
(45) Veröffentlichungstag und Bekanntmachung des Hinweises auf die Patenterteilung: **11.04.2012**
(21) Anmeldenummer: 07819337.2
(22) Anmeldetag: 26.10.2007
(51) Int. Cl.: H01J 37/26

(54) **PHASENPLATTE, BILDERZEUGUNGSVERFAHREN UND ELEKTRONENMIKROSKOP**
PHASE PLATE, IMAGE PRODUCING METHOD AND ELECTRON MICROSCOPE
LAME DE PHASE, PROCÉDÉ D'IMAGERIE ET MICROSCOPE ÉLECTRONIQUE

(30) Priorität: 24.11.2006 DE 102006055510
(43) Veröffentlichungstag der Anmeldung: 12.11.2008
(73) Patentinhaber: Ceos Corrected Electron Optical Systems GmbH, 69126 Heidelberg (DE)
(72) Erfinder: ZACH, Joachim, 76684 Östringen (DE)
(74) Vertreter: Weber, Walter
(86) Internationale Anmeldenummer: PCT/EP2007/009289
(87) Internationale Veröffentlichungsnummer: WO 2008/061603

(56) Entgegenhaltungen:
- EP-A- 0 782 170
- WO-A-03/068399
- JP-A- 2006 162 805
- US-A1- 2003 066 964
- MATSUMOTO ET AL: "The phase constancy of electron waves traveling through Boersch's electrostatic phase plate" ULTRAMICROSCOPY, AMSTERDAM, NL, Bd. 63, Nr. 1, April 1996 (1996-04), Seiten 5-10, XP022354692 ISSN: 0304-3991

## Beschreibung

Die Erfindung betrifft eine Phasenplatte für eine elektronenoptische Bildgebung, bei der an einem Objekt der Elektronenstrahl in einen Nullstrahl und gebeugte Elektronenstrahlen aufgespalten wird, wobei die Phasenplatte als Elektrode ausgebildet ist, um mittels eines durch eine Spannung erzeugten elektrischen Feldes eine Phasenverschiebung des Nullstrahls zu bewirken, um durch dessen Interferenz mit gebeugten Elektronenstrahlen ein kontrastreiches Bild zu erzielen.

Die Erfindung betrifft weiterhin ein Bilderzeugungsverfahren, bei dem ein elektronenoptisch erzeugtes Bild, bei dem Bildinformationen aufgrund einer partiellen Abschattung des Strahlengangs gebeugter Strahlen verloren gegangen sind, dadurch rekonstruiert wird, daß die mit den verlorenen Bildinformationen identischen, zum Nullstrahl zentralsymmetrisch gegenüberliegenden Bildinformationen herangezogen werden.

Des weiteren betrifft die Erfindung ein Elektronenmikroskop, bei dem eine Phasenplatte der oben genannten Art in der Objektivbrennebene des Nullstrahls angeordnet ist.

Wie in der Lichtmikroskopie sind auch in der Elektronenmikroskopie viele Objekte für den Strahl nahezu transparent, so daß bei konventioneller Abbildung nur wenig Amplitudenkontrast entsteht. Beide Strahlenarten erfahren beim Durchgang durch das Objekt aber eine von der Struktur des Objekts abhängige ortsveränderliche Phasenverschiebung. Der Strahl spaltet sich hierdurch im Objekt in einen ungebeugten sogenannten Nullstrahl und in abgebeugte Strahlen mehrerer Beugungsordnungen auf.

Beaufschlagt man den Nullstrahl mit einer Phasenverschiebung, bevorzugt 90°, so wird bei der Wiederüberlagerung des Nullstrahls mit den abgebeugten Strahlen in der

Bildebene die Phasenmodulation des Objekts in einen starken Amplitudenkontrast umgewandelt. Dies ist der bekannte Phasenkontrast (siehe z. B. Reimer, Transmission Electron Microscopy, S. 199 ff, Berlin, Heidelberg, New York 1984). Für eine solche Phasenverschiebung nutzt man die Tatsache, daß die Strahlen in der Brennebene des Objektivs verschiedene Brennpunkte bilden, so daß in der Brennebene für den Nullstrahl dieser einen zentralen Brennpunkt bildet und von den Brennpunkten der gebeugten Strahlen der verschiedenen Beugungsordnungen, beginnend mit der Beugung erster Ordnung umgeben wird, die im Wesentlichen in der gleichen Brennebene liegen. Diese Tatsache kann man dazu nutzen, eine Phasenverschiebung entweder des Nullstrahls oder der gebeugten Strahlen herbeizuführen, um den Phasenunterschied aufzuheben, damit sich die Amplituden verstärken. Dabei geht die Erfindung von einer Phasenverschiebung des Nullstrahls aus.

Im Gegensatz zur Lichtoptik besteht bei Elektronenstrahlen jedoch das Problem, daß es für sie keine transparente Platte gibt, die eine Phasenplatte tragen kann. Zur Lösung dieses Problems wurden daher Phasenplatten der eingangs genannten Art vorgeschlagen, die sich jedoch bezüglich der konkreten Ausgestaltungen unterscheiden, welche nachfolgend erörtert werden. Zu allen Phasenplatten dieser Art ist noch anzumerken, daß es technisch nicht realisierbar ist, allein den Nullstrahl zu erfassen, da ein elektrisches Feld im Nanometerbereich erforderlich wäre, was mit den derzeitigen technischen Möglichkeiten nicht erzeugt werden kann. Darum werden je nach Ausgestaltung der jeweiligen Phasenplatte zumindest wenige niedrige Beugungsordnungen miterfaßt. Der Begriff "Phasenplatte", welcher aus der Lichtmikroskopie stammt, wird im Bereich der Elektronenmikroskopie - da es sich meist nicht um plattenförmige Bauteile handelt - eher symbolisch verwendet und beinhaltet die Bauteile, die zur Erzielung der Phasenverschiebung erforderlich sind.

Von der EP 0 782 170 A2 wird eine Phasenplatte und ein Elektronenmikroskop vorgeschlagen, bei der eine ringförmige Elektrode vorgesehen ist, welche eine Bohrung im Bereich des Nullstrahls aufweist, in der sie das phasenverschiebende elektrische Feld erzeugt. Die ringförmige Elektrode ist an gegenüberliegenden Seiten an Haltearmen angebunden, die sich zum Gehäuse des Elektronenmikroskops erstrecken. Eine solche Phasenplatte hat mehrere Nachteile: Zunächst schirmt der Ring, der aus mechanischen und Fertigungsgründen eine gewisse Abmessung aufweisen muß, Strahlen in der Nähe des Nullstrahls ab. Da es sich dabei jedoch um die gebeugten Strahlen der höchsten Intensität handelt, gehen sehr viele Strahlen für die Kontrastbildung verloren. Weiterhin muß die Öffnung des Rings sehr klein sein, um nicht zu viele der niedrigen Beugungsordnungen in die Phasenverschiebung einzubeziehen, da diese dann für die Kontrastbildung ebenfalls verlorengehen. Dies hat jedoch wiederum zur Folge, daß diese kleine zentrale Bohrung sehr rasch verschmutzen und durch Kontamination zuwachen kann. Ein weiterer Nachteil besteht darin, daß die Haltearme für den Ring durch den Strahlengang der Strahlen höherer Beugung hindurch verlaufen, so daß auch hier eine Abschattung und damit ein Informationsverlust eintritt.

Zur Lösung des letztgenannten Problems wurde von der DE 102 06 703 A1 eine Phasenplatte und ein Verfahren der eingangs genannten Art vorgeschlagen, wobei die Ringelelektrode von Haltearmen gehalten wird, die nicht zentralsymmetrisch angeordnet sind, so daß es keine Abschattungen durch Arme gibt, die sich bezüglich des Nullstrahls, der durch die Bohrung der Ringelektrode hindurchgeht, um 180° versetzt gegenüberliegen. Dies ermöglicht es, die Abschattungen der Haltearme durch ein Bilderzeugungsverfahren der eingangs genannten Art zu rekonstruieren. Dabei bleiben jedoch die oben genannten Probleme mit der Ringelelektrode ungelöst, insbesondere erstreckt sich deren Abschattung über den Bereich eines um die optische Achse verlaufenden Rings, was insoweit jegliche Rekombinationsmöglichkeit der genannten Art ausschließt.

Aus der DE 10 2005 040 267 A1 ist ein Verfahren zur Erzeugung einer Phasenplatte der vorgenannten Art mit Ringelektrode bekannt, die durch Schichten in Sandwichbauweise aufgebaut und dann mit der Bohrung für die Ringelektrode versehen wird. Letztere weist jedoch auch hier die oben genannte Abschattung auf.

Bei einem Vorschlag der JP 2006162805 A geht es darum, die Adhäsion von Schutzteilchen an einer Phasenplatte durch elektrostatische Kräfte zu verhindern. Dazu wird ein entsprechender Schichtaufbau einer Phasenplatte vorgeschlagen. Diese Gestaltung der Phasenplatte hat jedoch mit der oben genannten Frage einer Bildrekombination durch zentralsymmetrisch gegenüberliegende Bildinformationen nichts zu tun.

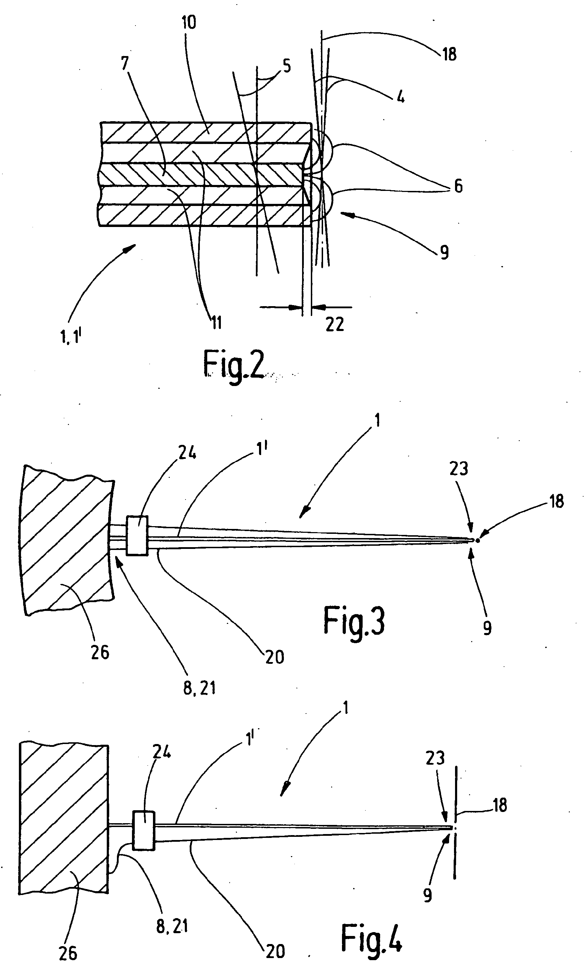

Durch einen weiteren Vorschlag der EP 0 782 170 A2 wird auf die Ringsruktur der Elektrode verzichtet, womit auch die vorgenannten Probleme mit der Ringelelektrode entfallen. Dieser Vorschlag gemäß Fig. 3 und der zugehörigen Beschreibung entspricht der Phasenplatte der eingangs genannten Art. Für die Frage, wie dann eine solche Elektrode aussehen soll, wird nur ein einziger Vorschlag gemacht, der darin besteht, einen Leiter unmittelbar tangential an dem Nullstrahl vorbeizuführen. Damit das von diesem Leiter ausgehende elektrische Feld möglichst nur den Nullstrahl erfaßt, wird in Fig. 3 und der zugehörigen Beschreibung vorgeschlagen, ihn mit einer Isolierschicht und einer geerdeten Abschirmungsschicht zu umgeben, welche im Bereich des Nullstrahls um den Umfang des gesamten Leiters herum entfernt ist, so daß dort ein elektrisches Feld zwischen dem Leiter und den beiden kreisringförmigen Enden der Abschirmungsschichten entsteht, welches an einer Seite des Leiters den Nullstrahl erfaßt. Dabei bestehen zwar nicht mehr die oben genannten Probleme mit der Ringelektrode, jedoch besteht weiterhin das Problem, daß der abgeschirmte Leiter durch den gesamten Strahlengang der gebeugten Strahlen hindurchgeht und eine entsprechend große Abschattung erzeugt. Vor allem ist aber dieser Leiter mit Isolation und Abschirmung gegenüber dem Brennpunkt des Nullstrahls so wenig versetzt, daß auch hier zentralsymmetrisch zum Brennpunkt des Nullstrahls um 180° versetzte Bereiche abgeschattet sind. Abgesehen davon, daß die EP 0 782 170 A2 keine Rekombination vorschlägt, ist eine solche aufgrund der vorgenannten Tatsache nicht möglich. Als weiteres Problem kommt bei diesem Vorschlag hinzu, daß der Leiter auch auf der dem Nullstrahl abgewandten Seite ein elektrisches Feld erzeugt, da er auch dort ohne Abschirmung freiliegt. Dies führt dazu, daß dort verlaufende gebeugte Strahlen ebenfalls phasenverschoben werden und damit für eine Amplitudenverstärkung nicht mehr zur Verfügung stehen.

Schließlich wird von der DE 102 00 645 A1 vorgeschlagen, eine Aperturblende vorzusehen, welche eine ringförmige Phasenplatte trägt, die sich entlang der Blendenbegrenzung als schmaler Rand erstreckt und beispielsweise als ringförmige Elektrode mit einer Innenelektrode und äußeren Erdelektroden ausgebildet ist. Als Alternative ist diese ringförmige Phasenplatte von der Aperturblende nach innen versetzt und durch Arme gehalten. Damit der Nullstrahl in den Bereich des Feldes dieser Elektrode kommt, wird der Strahlengang entsprechend gekippt. Damit ist zwar das Problem gelöst, daß es keine kleine Bohrung gibt, die verschmutzen oder durch Kontamination zuwachsen kann. Andererseits muß man den Aufwand betreiben, den Strahlengang entsprechend um einen exakten Winkel zu kippen. Bei der ersten Ausführungsform schneidet die Aperturblende durch ihre Bogenform mehr als die Hälfte der gebeugten Strahlen weg, was eine Kombination der vorgeschlagenen Lösung mit der oben dargestellten Bildrekonstruktion ausschließt. Bei der zweiten Ausführungsform liegt zwar die Aperturblende außerhalb des Strahlengangs, jedoch wirkt das ringförmige Feld - dies ist auch bei der ersten Ausführungsform der Fall - nicht nur auf den Nullstrahl, sondern auch in Bögen durch den gesamten Strahlengang der verschiedenen Beugungsordnungen hindurch bis zum Rand des Strahlengangs. Durch diese Ausgestaltung des elektrischen Feldes ist der davon beeinflußte Teil der gebeugten Strahlen durch die mittels des Feldes erzeugte Phasenverschiebung nicht mehr für eine Amplitudenverstärkung verwendbar. Außerdem ist auch eine Rekombination des Bildes nicht möglich, weil das Feld Bereiche erfaßt, die zum Nullstrahl um 180° gegenüberliegen.

Der Erfindung liegt daher die Aufgabe zugrunde, eine Phasenplatte und ein Elektronenmikroskop verfügbar zu machen, bei denen die Abschattungen durch die Phasenplatte auf ein Minimum reduziert sind und keinerlei Abschattungen auftreten, welche sich nicht rekonstruieren lassen. Bezüglich des Bilderzeugungsverfahrens besteht die Aufgabe darin, eine vollständige Rekombination des Bildes zu ermöglichen. Bezüglich der Phasenplatte der eingangs genannten Art wird die Aufgabe dadurch gelöst, daß die Elektrode als abgeschirmter Leiter ausgebildet ist, der von einer Befestigung im Wesentlichen sich radial in Richtung des Bereichs des Nullstrahls erstreckend anordenbar ist, wobei der abgeschirmte Leiter vor dem Bereich des Nullstrahls ein Ende aufweist, derart, daß zwischen dem Leiter und der ihn umgebenden Abschirmung ein Feld gebildet wird, das diesen Bereich erfaßt.

Bezüglich des Bilderzeugungsverfahrens der eingangs genannten Art wird die Aufgabe dadurch gelöst, daß durch die Verwendung einer vollständig auf einer Seite des Nullstrahls liegenden Phasenplatte, die der Erzeugung einer Phasenverschiebung desselben dient, eine vollständige Rekonstruktion des Bildes erfolgt.

Bezüglich des Elektronenmikroskops der eingangs genannten Art wird die Aufgabe dadurch gelöst, daß die Elektrode als abgeschirmter Leiter ausgebildet ist, der sich von einer Befestigung ausgehend im Wesentlichen radial in Richtung des Bereichs des Nullstrahls erstreckt, wobei der abgeschirmte Leiter vor dem Bereich des Nullstrahls ein Ende aufweist, derart, daß ein zwischen Abschirmung und Leiter gebildetes Feld diesen Bereich erfaßt.

Der Grundgedanke der Erfindung besteht darin, daß das elektrische Feld von einem Leiterende möglichst geringen Ausmaßes erzeugt wird, das durch einen Isolator getrennt von einer geerdeten ebenfalls leitenden Umhüllung umgeben ist. Auf diese Weise läßt sich zwischen dem Leiter und der umhüllenden Abschirmung ein elektrisches Feld sehr kleinen Ausmaßes erzeugen, um neben dem Nullstrahl sowenig gebeugte Strahlen wie möglich durch das Feld zu erfassen oder abzuschirmen, womit möglichst viele, in der Nähe des Nullstrahls befindliche, intensitätsstarke gebeugte Strahlen für die Kostrastbildung nutzbar bleiben. Neben diesem Vorteil bietet die erfindungsgemäße Phasenplatte die Möglichkeit, das elektrische Feld nur von einer Seite an den Nullstrahl heranzuführen, so daß es zu keiner Abschattung von Bereichen kommt, welche sich bezüglich des Nullstrahls um 180° gegenüberliegen. Die erfindungsgemäße Phasenplatte ermöglicht auf diese Weise ein Bilderzeugungsverfahren mit einer vollständigen Rekonstruktion des Bildes. Bezüglich weiterer konkreter Ausgestaltungen des Bilderzeugungsverfahrens wird auf Vorveröffentlichtes, insbesondere auf die DE 102 06 703 A1 verwiesen. Erfindungsgemäß ist mit diesem Verfahren erstmals eine vollständige Bildrekonstruktion möglich.

Damit ist auch ein Elektronenmikroskop verfügbar, das durch die Ausstattung mit der erfindungsgemäßen Phasenplatte und einem Bilderzeugungsverfahren, das die Abschattung dieser Phasenplatte vollständig rekonstruiert, kontrastreiche Bilder semitransparenter Objekte liefert, ohne daß Bildbereiche durch die Abschattung hinsichtlich ihrer Qualität beeinträchtigt sind.

Eine Weiterbildung der Phasenplatte sieht vor, daß der als Innenelektrode dienende Leiter an seinem Ende gegenüber der ihn umgebenden Abschirmung leicht zurückversetzt ist. Auf diese Weise ist es möglich, das erzeugte Feld noch enger zu begrenzen und dadurch neben dem Nullstrahl noch weniger gebeugte Strahlen zu erfassen. Dadurch gehen letztere für eine Interferenzbildung mit dem Nullstrahl nicht verloren und die Bilder werden noch kontrastreicher.

Da zwischen Leiter und Abschirmung normalerweise ein Isolator angeordnet ist, kann es zweckmäßig sein, daß der Isolator gegenüber dem Leiter und der Abschirmung zurückversetzt ist. Auf diese Weise kann vermieden werden, daß der Isolator durch eine Strahlung aufgeladen wird, was nicht nur die Erzeugung des Feldes stört, sondern unter Umständen auch dazu führen kann, daß die Stabilität des Nullstrahle gestört wird. Eine Aufladung des Isolators kann jedoch alternativ oder zusätzlich auch dadurch vermieden werden, daß der Isolator eine Restleitfähigkeit aufweist, die derart bemessen ist, daß eine mögliche Aufladung derart abgeleitet wird, daß eine Störung des Feldes und/oder eine Ablenkung des Nullstrahls ausgeschlossen ist.

Ein weiterer Vorschlag besteht darin, daß die Elektrode durch einen Träger gehalten ist. Um das elektrische Feld möglichst klein zu halten, ist es erforderlich, die Elektrode mit Leiter, Isolator und Abschirmung mit einem möglichst geringen Querschnitt auszubilden, wobei die kleinste technisch mögliche und wirtschaftlich noch vertretbare Abmessung angestrebt wird. Damit reicht die Steifigkeit nicht mehr aus, damit sich die Elektrode selbst trägt. Die Halterung durch den Träger dient deshalb dazu, daß die Elektrode mit möglichst geringem Querschnitt ausgebildet werden kann.

Damit der Träger nicht energiereiche Strahlen niedriger Beugungsordnung abschirmt, ist es zweckmäßig, wenn die Elektrode am vorderen Ende des Trägers so weit übersteht, wie dies aufgrund ihrer Steifigkeit und damit Eigentragfahigkeit möglich ist. Diesem Zweck dient auch ein Querschnitt des Trägers, der sich von außen nach innen verjüngt. Auf diese Weise wird die Abschirmung dort am geringsten gehalten, wo sie am meisten Strahlenintensität wegnimmt, und gleichzeitig weist der Träger dort einen größeren Querschnitt auf, wo dies aus statischen Gründen erforderlich ist.

Da die Elektrode mit ihrem Ende, an dem das elektrische Feld gebildet wird, nur einen äußerst geringen Abstand zum Nullstrahl aufweisen sollte, um nur diesen zu erfassen, ist es zweckmäßig, wenn Vorkehrungen getroffen werden, die eine jederzeitige Nachjustierung möglich machen. Zu diesem Zweck wird als Weiterbildung der Phasenplatte vorgeschlagen, daß die Elektrode mit einer Stellmechanik ausgestattet ist, mittels der das Ende des abgeschirmten Leiters zum Bereich des Nullstrahls einstellbar ist. Zum selben Zweck kann zusätzlich oder alternativ vorgesehen sein, daß der Elektrode eine Strahlablenkungsvorrichtung in Strahlrichtung vorgeordnet ist, durch welche der Nullstrahl derart ablenkbar ist, daß er sich in Relation zum elektrischen Feld positionieren läßt.

Bezüglich des o.g. Bilderzeugungsverfahrens ist als zweckmäßige Weiterbildung vorgesehen, daß der Bildkontrast erfaßt wird und daß das elektrische Feld bezüglich Stärke und/oder seiner Positionierung in Relation zum Nullstrahl bis zur Erzielung eines optimalen Bildkontrasts verändert werden. Das Verfahren wird dabei zweckmäßigerweise mittels einer entsprechenden Regeleinrichtung durchgeführt. Dabei wird das elektrische Feld mittels des entsprechenden Spannungspotentials eingestellt. Die Relation zwischen dem elektrischen Feld und dem Nullstrahl kann entweder dadurch eingestellt werden, daß die Phasenplatte mit ihrem das Feld erzeugenden Ende zur Optimierung der Phasenverschiebung positioniert wird. Eine andere Möglichkeit besteht darin, daß der Nullstrahl zur Optimierung der Phasenverschiebung in Relation zum Feld durch Ablenkung positioniert wird.

Das Elektronenmikroskop kann mit einer Phasenplatte ausgestattet sein, die alle vorgenannten Weiterbildungen aufweist. Weiterhin kann das Elektronenmikroskop derart ausgestaltet sein, daß es nach allen Weiterbildungen des vorgenannten Bilderzeugungsverfahrens arbeiten kann. Insbesondere kann das Elektronenmikroskop entsprechend der vorbeschriebenen Phasenplatte mit einer Stellmechanik für die Elektrode ausgestattet sein, mittels der das Ende des abgeschirmten Leiters zum Bereich des Nullstrahls einstellbar ist. Alternativ oder gleichzeitig kann vorgesehen sein, daß das Elektronenmikroskop eine der Elektrode vorgeordnete Strahlablenkungsvorrichtung aufweist, durch welche der Nullstrahl derart ablenkbar ist, daß er sich in Relation zum elektrischen Feld positionieren läßt. Eine derartige Strahlablenkungsvorrichtung kann vor dem Objekt, zwischen Objekt und Objektiv oder zwischen Objektiv und der Objektivbrennebene des Nullstrahls angeordnet sein. Es kann sich dabei um eine Einrichtung zur Erzeugung eines elektrischen Feldes und/oder eines magnetischen Feldes handeln, mit der sich der Nullstrahl in die optimale Position zu dem phasenverschiebenden Feld bringen läßt. Durch die vorgenannten Felder werden natürlich auch die gebeugten Strahlen erfaßt und mit dem Nullstrahl justiert. Dies muß auch sein, da ihre Zentralsymmetrie zum Nullstrahl für die Wiederüberlagerung erhalten bleiben muß.

Eine weitere Ausgestaltung des Elektronenmikroskops sieht vor, daß eine Detektoreinrichtung sowie eine Bildauswertungs- und Regelungseinrichtung vorgesehen sind, mittels derer der Bildkontrast erfaßt und die Spannung zur Erzeugung des elektrischen Feldes geregelt wird. Weiterhin kann vorgesehen sein, daß diese Einrichtungen die Positionierung des Endes des abgeschirmten Leiters in Relation zum Nullstrahl mittels der Stellmechanik und/oder die Positionierung des Nullstrahls zum Ende des abgeschirmten Leiters mittels der Strahlablenkungsvorrichtung vornehmen. Diese Einstellungen werden mittels der Regeleinrichtung so lange vorgenommen, bis ein optimaler Bildkontrast erzielt ist. Ein entsprechend ausgebildetes Programm sorgt dabei für ein schnelles Auffinden der optimalen Einstellungen.

Die Erfindung wird nachfolgend anhand eines in der Zeichnung dargestellten Ausführungsbeispiels erläutert. Es zeigen
- Fig. 1: eine Prinzipdarstellung eines erfindungsgemäßen Elektronenmikroskops mit einer Phasenplatte,
- Fig. 2: die Elektrodenspitze einer erfindungsgemäßen Phasenplatte im Schnitt mit elektrischem Feld und Nullstrahl und
- Fig. 3 und 4: eine Phasenplatte mit Träger und Stellmechanik.

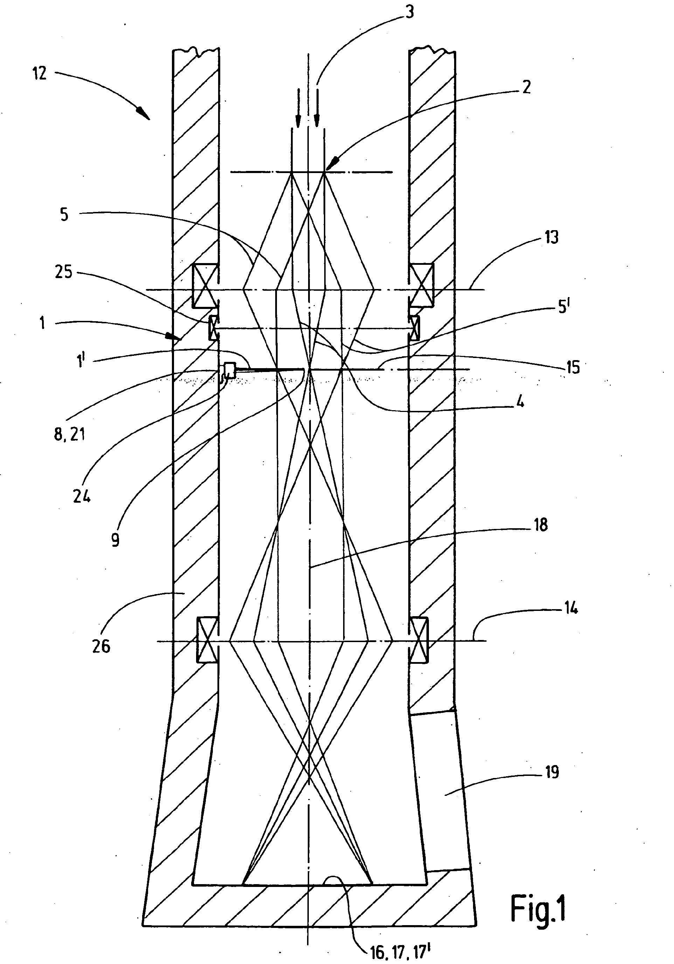

Fig. 1 zeigt eine Prinzipdarstellung eines Elektronenmikroskops 12 mit einer erfindungsgemäßen Phasenplatte 1, die als Elektrode 1' ausgebildet ist. Bezüglich des Elektronenmikroskops 12 sind nur die wesentlichen Bestandteile dargestellt, wobei auch die Strahlerzeugung und der Bereich der Formung des Strahls weggelassen wurden. Nur der darunterliegende Röhrenteil des Elektronenmikroskops 12 ist dargestellt, welcher eingelagert in die Gehäusewand 8 ein Objektiv 13, eine Projektionslinse 14, den Bildschirm 16 und Detektoreinrichtungen 17 beziehungsweise 17' enthält. Auf die Darstellung eines Zwischenlinsensystems oder sonstiger Einrichtungen wurde ebenfalls verzichtet.

Der Elektronenstrahl 3 ist auf ein Objekt 2 gerichtet und wird dort teilweise gebeugt, so daß neben dem Nullstrahl 4 gebeugte Elektronenstrahlen 5, 5' entstehen. Die Strahlen 4,5,5' werden durch das Objektiv 13 gebrochen, wobei die Brennpunkte der Strahlen 4, 5, 5' in der Objektivbrennebene 15 des Nullstrahls 4 liegen. Beispielhaft wurden dabei nur zwei um 180° versetzten Brennpunkte von gebeugten Strahlen 5, 5' einer Beugungsordnung eingezeichnet. Die Bezeichnung Objektivbrennebene 15 des Nullstrahls 4 wurde gewählt, weil dessen Brennpunkt, wenn es zu - wenn auch geringfügigen- Abweichungen zu den Brennpunkten gebeugter Strahlen 5, 5' kommt, den Bezugspunkt bildet. Die Brennpunkte der gebeugten Elektronenstrahlen 5, 5' liegen von dem Brennpunkt des Nullstrahls 4 in radialer Richtung entfernt, wobei der Brennpunkt des Nullstrahls 4 den Mittelpunkt bildet und außerhalb von den Brennpunkten aller gebeugter Elektronenstrahlen 5, 5', die in der Regel ein zentralsymmetrisches Muster bilden, abgestuft nach den Beugungsordnungen umgeben ist. Diese Tatsache wird dazu genutzt, mittels der Phasenplatte 1 mit der Elektrode 1' ein kleines elektrisches Feld 6 (siehe Fig. 2) zu erzeugen, das im Wesentlichen nur den Nullstrahl 4 erfaßt, womit dieser derart phasenverschoben werden kann, daß sich bei der Bildgebung auf der Projektionsfläche 16 oder der Detektoreinrichtung 17 oder 17' durch Amplitudenverstärkung bei der Wiederüberlagerung der Strahlen 4, 5, 5' ein kontrastreiches Bild ergibt.

Um zu gewährleisten, daß das elektrische Feld 6 im wesentlichen nur den Nullstrahl 4 erfaßt, ist es zweckmäßig, wenn eine Nachjustierung möglich ist, da die einzuhaltende äußerst geringe Distanz sich durch kleinste Einflüsse verändern kann. Darum wird vorgeschlagen, daß die Elektrode 1' mit dem Träger 20 eine Stellmechanik 24 aufweist, durch die es möglich ist, das Ende 9 des abgeschirmten Leiters 7 (siehe Fig. 2) in Relation zum Brennpunkt des Nullstrahls 4 nachzujustieren. Die Stellmechanik 24 ist dabei nur symbolisch dargestellt. Alternativ oder gleichzeitig kann eine solche Nachjustage auch dadurch erzielt werden, daß eine Strahlablenkungsvorrichtung 25 vorgesehen ist. Diese ist in Strahlenrichtung der Objektivbrennebene 15 des Nullstrahls 4 vorgeordnet und derart beschaffen, daß sie durch die Erzeugung eines entsprechenden elektrischen oder magnetischen Feldes den Strahlengang 4, 5, 5' um sehr geringe Maße derart verschieben kann, daß sich der Brennpunkt des Nullstrahls 4 in einer optimalen Positionierung zum elektrischen Feld 6 befindet. Diese Positionierung ist in Fig. 2 vergrößert gezeichnet.

Zur Vollständigkeit wurde noch ein Sichtfenster 19 eingezeichnet, durch das auf der Projektionsfläche 16 das durch den Elektronenstrahl 3 erzeugte Bild unmittelbar betrachtet werden kann. Nicht eingezeichnet ist die Steuerung, welche das Bilderzeugungsverfahren durchführt, indem sie mittels der durch die Detektoreinrichtung 17 gewonnenen Informationen ein rekonstruiertes Bild auf einem ebenfalls nicht eingezeichneten Bildschirm erzeugt

Zusätzlich zur Detektoreinrichtung 17 kann auch eine mit dieser identischen oder von dieser unterschiedlichen Detektoreinrichtung 17' vorgesehen sein, die dazu dient, die Positionierung des Nullstrahls 4 zum elektrischen Feld 6 sowie die Stärke des elektrischen Feldes 6 zu regeln, indem der Bildkontrast erfaßt wird und die genannten Größen zur Erzielung eines optimalen Bildkontrastes eingestellt werden.

**Fig. 2** zeigt die Elektrodenspitze einer Phasenplatte 1 im Schnitt mit elektrischem Feld 6 und Nullstrahl 4: Dabei befindet sich der Nullstrahl 4 in der optischen Achse 18, die auch in Fig. 1 eingezeichnet ist. Mit den vorgenannten Mitteln ist es möglich, das Ende 9 des abgeschirmten Leiters 7 derart exakt zu positionieren, daß das elektrische Feld 6 außer dem Nullstrahl 4 nur sehr wenige gebeugte Elektronenstrahlen 5, 5' miterfaßt. Das elektrische Feld 6 kann dadurch noch etwas genauer lokalisiert werden, daß der die Innenelektrode bildende Leiter 7 gegenüber der Abschirmung 10 eine Zurückversetzung 22 aufweist, da das Feld 6 auf diese Weise noch mehr begrenzt werden kann. Die Elektrode 1' besteht aus dem Leiter 7, einem Isolator 11 und der Abschirmung 10, wobei der Querschnitt der Elektrode 1' kleinstmöglich ausgebildet wird, um das elektrische Feld 6 möglichst im Bereich des Brennpunktes des Nullstrahls 4 zu lokalisieren.

Die Fig. 3 und 4 zeigen eine Phasenplatte 1, bei der die Elektrode 1' durch einen Träger 20 gehalten ist, welcher mittels einer Befestigung 8, beispielsweise einer Halterung 21 an der Gehäusewand 26 des Elektronenmikroskops 12 befestigt ist. Der Träger 20 weist im Bereich der Gehäusewand 26 einen relativ breiten Querschnitt auf und verjüngt sich in Richtung der optischen Achse 18. Auf diese Weise ist überall der statisch notwendige Querschnitt vorhanden und die Abschirmung von Strahlen 5, 5' durch den Träger 20, insbesondere in der Nähe der optischen Achse 18, wird auf ein Minimum reduziert. Dies wird noch dadurch verbessert, daß die Elektrode 1' gegenüber dem Träger 20 einen Überstand 23 aufweist, der derart bemessen ist, daß sich die Elektrode 1' in diesem Bereich selbst tragen kann. Mit dem eingezeichneten Kasten ist symbolisch eine Stellmechanik 24 eingezeichnet, durch die es möglich ist, das Ende 9 des abgeschirmten Leiters 7 und damit das Feld 6 in die optimale Position zum Nullstrahl 4 zu bringen.

Die Darstellung in der Zeichnung ist selbstverständlich nur beispielhaft. Die erfindungsgemäße Phasenplatte 1 kann natürlich bei verschiedensten elektronenoptischen Bildgebungen eingesetzt werden, die mitunter auch anders aufgebaut sind, wie das dargestellte Elektronenmikroskop 12. Auch die Gestaltung der Elektrode 1' sowie des Trägers 20 können unterschiedlich sein, insbesondere kann die Querschnittsfläche der Elektrode 1' verschieden ausgebildet sein, man kann eine runde, quadratische oder rechteckige Form wählen. Auch kann vorgesehen sein, daß zur Erzeugung eines möglichst kleinen elektrischen Feldes 6 die Elektrode 1' nicht auf ihrer ganzen Länge den gleichen Querschnitt aufweist, sondern eine Spitze besitzt, die sich noch zu einem kleineren Querschnitt verjüngt. Erfindungswesentlich ist letztendlich nur, daß es keinerlei Abschattung gibt, die zum Nullstrahl 4 zentralsymmetrisch um 180° versetzt ist. Alle Ausgestaltungen, die diese Bedingung erfüllen, machen vom Grundgedanken der Erfindung Gebrauch.

### Phasenplatte, Bilderzeugungsverfahren und Elektronenmikroskop

### Bezugszeichenliste

- 1: Phasenplatte
- 1': Elektrode
- 2: Objekt
- 3: Elektronenstrahl
- 4: Nullstrahl
- 5, 5': gebeugte Elektronenstrahlen
- 6: elektrisches Feld
- 7: abgeschirmter Leiter
- 8: Befestigung (z. B. an der Gehäusewand)
- 9: Ende des abgeschirmten Leiters
- 10: Abschirmung
- 11: Isolator
- 12: Elektronenmikroskop
- 13: Objektiv
- 14: Projektionslinse
- 15: Objektivbrennebene des Nullstrahls
- 16: Projektionsfläche
- 17, 17': Detektoreinrichtung
- 18: optische Achse
- 19: Sichtfenster
- 20: Träger
- 21: Halterung
- 22: Zurückversetzung
- 23: Überstand
- 24: Stellmechanik
- 25: Strahlablenkungsvorrichtung
- 26: Gehäusewand

## Patentansprüche

1. Phasenplatte (1) für eine elektronenoptische Bildgebung, bei, der an einem Objekt (2) der Elektronenstrahl (3) in einen Nullstrahl (4) und gebeugte Elektronenstrahlen (5, 5') aufgespalten wird, wobei die Phasenplatte (1) als sich in den Bereich des Nullstrahls (4) erstreckende Elektrode (1') ausgebildet ist, um mittels eines durch eine Spannung erzeugten elektrischen Feldes (6) eine Phasenverschiebung des Nullstrahls (4) zu bewirken, um durch dessen Interferenz mit gebeugten Elektronenstrahlen (5, 5') ein kontrastreiches Bild zu erzielen,
**dadurch gekennzeichnet,**
**daß** die Elektrode (1') als abgeschirmter Leiter (7) ausgebildet ist, der von einer Befestigung (8) im Wesentlichen sich radial in Richtung des Bereichs des Nullstrahls (4) erstreckend angeordnet ist, wobei der abgeschirmte Leiter (7) vor dem Bereich des Nullstrahls (4) ein Ende (9) aufweist, derart, daß zwischen dem Leiter (7) und der ihn umgebenden Abschirmung (10) ein Feld (6) gebildet wird, das diesen Bereich erfaßt.

2. Phasenplatte nach Anspruch 1,
**dadurch gekennzeichnet,**
**daß** der als Innenelektrode dienende Leiter (7) an seinem Ende (9) gegenüber der ihn umgebenden Abschirmung (10) leicht zurückversetzt ist.

3. Phasenplatte nach Anspruch 1 oder 2,
**dadurch gekennzeichnet,**
**daß** zwischen Leiter (7) und Abschirmung (10) ein Isolator (11) angeordnet ist.

4. Phasenplatte nach Anspruch 3,
**dadurch gekennzeichnet,**
**daß** der Isolator (11) gegenüber dem Leiter (7) und der Abschirmung (10) zurückversetzt ist.

5. Phasenplatte nach Anspruch 3 oder 4,
**dadurch gekennzeichnet,**
**daß** der Isolator (11) eine Restleitfähigkeit aufweist, die derart bemessen ist, daß eine mögliche Aufladung derart abgeleitet wird, daß eine Störung des Feldes (6) und/oder eine Ablenkung des Nullstrahls (4) ausgeschlossen ist.

6. Phasenplatte nach einem der Ansprüche 1 bis 5,
**dadurch gekennzeichnet,**
**daß** die Elektrode (1') durch einen Träger (20) gehalten ist.

7. Phasenplatte nach Anspruch 6,
**dadurch gekennzeichnet,**
**daß** die Elektrode (1') am vorderen Ende des Trägers (20) übersteht.

8. Phasenplatte nach Anspruch 6 oder 7,
**dadurch gekennzeichnet,**
**daß** sich der Querschnitt des Trägers (20) von außen nach innen verjüngt.

9. Phasenplatte nach einem der Ansprüche 1 bis 8,
**dadurch gekennzeichnet,**
**daß** die Elektrode (1') mit einer Stellmechanik (24) ausgestattet ist, mittels der das Ende (9) des abgeschirmten Leiters (7) zum Bereich des Nullstrahls (4) einstellbar ist.

10. Phasenplatte nach einem der Ansprüche 1 bis 8,
**dadurch gekennzeichnet,**
**daß** der Elektrode (1') eine Strahlablenkungsvorrichtung (25) in Strahlrichtung vorgeordnet ist, durch welche der Nullstrahl (4) derart ablenkbar ist, daß er sich in Relation zum elektrischen Feld (6) positionieren läßt.

11. Bilderzeugungsverfahren, bei dem ein elektronenoptisch erzeugtes Bild, bei dem Bildinformationen aufgrund einer partiellen Abschattung des Strahlengangs gebeugter Strahlen (5,5') verloren gegangen sind, dadurch rekonstruiert wird, daß die mit den verlorenen Bildinformationen identischen, zum Nullstrahl (4) zentralsymmetrisch gegenüberliegenden Bildinformationen herangezogen werden, **dadurch gekennzeichnet,**
**daß** durch die Verwendung einer vollständig auf einer Seite des Nullstrahls (4) liegenden Phasenplatte (1), die der Erzeugung einer Phasenverschiebung desselben dient, eine vollständige Rekonstruktion des Bildes erfolgt.

12. Bilderzeugungsverfahren nach Anspruch 11,
**dadurch gekennzeichnet,**
**daß** der Bildkontrast erfaßt wird und daß das elektrische Feld (6) bezüglich Stärke und/oder seiner Positionierung in Relation zum Nullstrahl (4) bis zur Erzielung eines optimalen Bildkontrasts verändert werden.

13. Bilderzeugungsverfahren nach Anspruch 11 oder 12,
**dadurch gekennzeichnet,**
**daß** die Phasenplatte (1) mit ihrem felderzeugenden Ende (9) zur Optimierung der Phasenverschiebung in Relation zum Nullstrahl (4) positioniert wird.

14. Bilderzeugungsverfahren nach Anspruch 11 oder 12,
**dadurch gekennzeichnet,**
**daß** der Nullstrahl (4) zur Optimierung der Phasenverschiebung in Relation zum Feld (6) durch Ablenkung positioniert wird.

15. Elektronenmikroskop (12), bei dem an einem Objekt (2) der Elektronenstrahl (3) in einen Nullstrahl (4) und gebeugten Elektronenstrahlen (5, 5') aufgespaltet wird, mit einer Phasenplatte (1), die in der Objektivbrennebene (15) des Nullstrahls (4) angeordnet ist, wobei die Phasenplatte (1) als Elektrode (1') ausgebildet ist, um mittels eines durch eine Spannung erzeugten elektrischen Feldes (6) eine Phasenverschiebung des Nullstrahls (4) zu bewirken, um durch dessen Interferenz mit gebeugten Elektronenstrahlen (5, 5') ein kontrastreiches Bild zu erzielen,
**dadurch gekennzeichnet,**
**daß** die Elektrode (1') als abgeschirmter Leiter (7) ausgebildet ist, der sich von einer Befestigung (8) ausgehend im Wesentlichen radial in Richtung des Bereichs des Nullstrahls (4) erstreckt, wobei der abgeschirmte Leiter (7) vor dem Bereich des Nullstrahls (4) ein Ende (9) aufweist, derart, daß ein zwischen Abschirmung (10) und Leiter (7) gebildetes Feld (6) diesen Bereich erfaßt.

16. Elektronenmikroskop nach Anspruch 15,
**dadurch gekennzeichnet,**
**daß** es mit einer Einrichtung zur Bilderzeugung ausgestattet ist, die derart ausgebildet ist, daß ein elektronenoptisch erzeugtes Bild, bei dem Bildinformationen aufgrund einer partiellen Abschattung des Strahlengangs durch die Phasenplatte (1) verloren gegangen sind, mittels einer Detektoreinrichtung (17) erfaßt und dadurch rekonstruiert wird, daß die mit den verlorenen Bildinformationen identischen, zum Nullstrahl (4) zentralsymmetrisch gegenüberliegenden Bildinformationen herangezogen werden, wobei die Rekonstruktion lückenlos erfolgt, da die Phasenplatte (1) vollständig auf einer Seite des Nullstrahls (4) liegt.

17. Elektronenmikroskop nach Anspruch 15 oder 16,
**dadurch gekennzeichnet,**
**daß** es eine Stellmechanik (24) für die Elektrode (1') aufweist, mittels der das Ende (9) des abgeschirmten Leiters (7) zum Bereich des Nullstrahls (4) einstellbar ist.

18. Elektronenmikroskop nach Anspruch 15 oder 16,
**dadurch gekennzeichnet,**
**daß** es eine der Elektrode (1') vorgeordnete Strahlablenkungsvorrichtung (25) aufweist, durch welche der Nullstrahl (4) derart ablenkbar ist, daß er sich in Relation zum elektrischen Feld (6) positionieren läßt.

19. Elektronenmikroskop nach Anspruch 15 bis 18,
**dadurch gekennzeichnet,**
**daß** eine Detektoreinrichtung (17') sowie eine Bildauswertungs- und Regelungseinrichtung vorgesehen sind, mittels derer der Bildkontrast erfaßt und die Spannung zur Erzeugung des elektrischen Feldes (6) geregelt sowie die Positionierung des Endes (9) des abgeschirmten Leiters (7) in Relation zum Nullstrahl (4) mittels der Stellmechanik (24) und/oder die Positionierung des Nullstrahls (4) zum Ende (9) des abgeschirmten Leiters (7) mittels der Strahlablenkungsvorrichtung (25) vorgenommen wird, bis ein optimaler Bildkontrast erzielt ist.

## Claims

1. Phase plate (1) for electron optical imaging, wherein the electron beam (3) is divided by an object (2) into a zero beam (4) and diffracted electron beams (5, 5'), wherein the phase plate (1) is designed as an electrode (1') that extends into the area of the zero beam (4) for phase-shifting the zero beam (4) using an electric field (6) generated by a voltage in order to obtain a high-contrast image by means of its interference with diffracted electron beams (5, 5'), **characterized in that** the electrode (1') is designed as a shielded conductor (7) which is disposed to extend substantially in a radial direction from a mounting (8) towards the area of the zero beam (4), wherein the shielded conductor (7) has an end (9) in front of the area of the zero beam (4), such that a field (6), which overlaps this area, is formed between the conductor (7) and the shielding (10) surrounding it.

2. Phase plate according to claim 1, **characterized in that** the end (9) of the conductor (7), which is used as an inner electrode, is slightly backwardly offset with respect to the surrounding shielding (10).

3. Phase plate according to claim 1 or 2, **characterized in that** an insulator (11) is disposed between the conductor (7) and the shielding (10).

4. Phase plate according to claim 3, **characterized in that** the insulator (11) is backwardly offset with respect to the conductor (7) and the shielding (10).

5. Phase plate according to claim 3 or 4, **characterized in that** the insulator (11) has a residual conductivity which is of such a magnitude that possible charge is discharged in such a fashion that disturbance of the field (6) and/or deflection of the zero beam (4) is prevented.

6. Phase plate according to any one of the claims 1 through 5, **characterized in that** the electrode (1') is held by a carrier (20).

7. Phase plate according to claim 6, **characterized in that** the electrode (1') protrudes past the front end of the carrier (20).

8. Phase plate according to claim 6 or 7, **characterized in that** the cross-section of the carrier (20) tapers from the outside to the inside.

9. Phase plate according to any one of the claims 1 through 8, **characterized in that** the electrode (1') is provided with an actuating mechanism (24) by means of which the end (9) of the shielded conductor (7) can be adjusted with respect to the area of the zero beam (4).

10. Phase plate according to any one of the claims 1 through 8, **characterized in that** the electrode (1') has an upstream beam deflecting device (25) which can deflect the zero beam (4) in such a fashion that it can be positioned with respect to the electric field (6).

11. Imaging method, wherein an image that is generated through electron optics and of which image information was lost due to partial shading of the optical path of the diffracted beams (5, 5') is reconstructed by using the image information that is identical to the lost image information and located centrally symmetrically opposite to the zero beam (4), **characterized in that** the complete image can be reconstructed by using a phase plate (1) which is entirely disposed on one side of the zero beam (4) and is used to generate a phase shift thereof.

12. Imaging method according to claim 11, **characterized in that** the image contrast is detected and the electric field (6) is changed with respect to strength and/or positioning in relation to the zero beam (4) until an optimum image contrast is obtained.

13. Imaging method according to claim 11 or 12, **characterized in that** the field-generating end (9) of the phase plate (1) is positioned relative to the zero beam (4) in such a fashion that the phase shift is optimized.

14. Imaging method according to claim 11 or 12, **characterized in that** the zero beam (4) is positioned in relation to the field (6) through deflection in order to optimize the phase shift.

15. Electron microscope (12), wherein the electron beam (3) is divided by an object (2) into a zero beam (4) and diffracted electron beams (5, 5'), comprising a phase plate (1) disposed in the objective focal plane (15) of the zero beam (4), wherein the phase plate (1) is designed as an electrode (1') for phase-shifting the zero beam (4) using an electric field (6) generated by a voltage in order to obtain a high-contrast image by means of its interference with diffracted electron beams (5, 5'), **characterized in that** the electrode (1') is designed as a shielded conductor (7) which extends from a mounting (8) in a substantially radial direction towards the area of the zero beam (4), wherein the shielded conductor (7) has an end (9) in front of the area of the zero beam (4), such that a field (6) formed between the shielding (10) and the conductor (7) overlaps this area.

16. Electron microscope according to claim 15, **characterized in that** it comprises an imaging means which is designed in such a fashion that an image that is generated through electron optics and of which image information was lost due to partial shading of the optical path through the phase plate (1), is detected by a detector means (17) and reconstructed by using the image information identical to the lost image information and located centrally symmetrically opposite to the zero beam (4), wherein reconstruction is complete since the entire phase plate (1) is located on one side of the zero beam (4).

17. Electron microscope according to claim 15 or 16, **characterized in that** it comprises an actuating mechanism (24) for the electrode (1') for adjusting the end (9) of the shielded conductor (7) with respect to the area of the zero beam (4).

18. Electron microscope according to claim 15 or 16, **characterized in that** it comprises a beam deflecting device (25) that is disposed upstream of the electrode (1'), through which the zero beam (4) can be deflected in such a fashion that it can be positioned relative to the electrical field (6).

19. Electron microscope according to claims 15 through 18, **characterized in that** a detector means (17') and an image evaluation and control means are provided for detecting the image contrast and controlling the voltage for generating the electric field (6) and positioning the end (9) of the shielded conductor (7) relative to the zero beam (4) using the actuating mechanism (24) and/or positioning the zero beam (4) towards the end (9) of the shielded conductor (7) using the beam deflecting device (25) until an optimum image contrast is obtained.

## Revendications

1. Plaque de phase (1) pour imagerie électro-optique, dans laquelle sur un objet (2) le faisceau d'électrons (3) est scindé en un faisceau nul (4) et des faisceaux d'électrons diffractés (5, 5'), dans laquelle la plaque de phase (1) est conçue comme une électrode (1') s'étendant dans la portée du faisceau zéro (4), afin de provoquer au moyen d'un champ électrique (6) généré par une tension un déphasage du faisceau zéro (4), afin de produire une image riche en contraste du fait de l'interférence de ce dernier avec les faisceaux d'électrons diffractés (5, 5'),
**caractérisée en ce que**
l'électrode (1') est réalisée comme un conducteur blindé (7), qui est disposé de manière à s'étendre à partir d'une fixation (8) essentiellement radialement dans la direction de la portée du faisceau zéro (4), dans laquelle le conducteur blindé (7) présente avant la portée du faisceau zéro (4) une extrémité (9), de telle sorte qu'un champ (6), qui détecte cette portée, soit formé entre le conducteur (7) et le blindage (10) qui l'entoure.

2. Plaque de phase selon la revendication 1,
**caractérisée en ce que**
le conducteur (7) servant d'électrode intérieure est légèrement ramené en arrière à son extrémité (9) par rapport au blindage (10) qui l'entoure.

3. Plaque de phase selon la revendication 1 ou 2,
**caractérisée en ce que**
un isolateur (11) est disposé entre le conducteur (7) et le blindage (10).

4. Plaque de phase selon la revendication 3,
**caractérisée en ce que**
l'isolateur (11) est ramené en arrière par rapport au conducteur (7) et au blindage (10).

5. Plaque de phase selon la revendication 3 ou 4,
**caractérisée en ce que**
l'isolateur (11) présente une conductivité résiduelle, qui est proportionnée de telle sorte qu'une éventuelle charge soit déviée de telle sorte qu'une perturbation du champ (6) et/ou une déviation du faisceau zéro (4) soit exclue.

6. Plaque de phase selon une des revendications 1 à 5,
**caractérisée en ce que**
l'électrode (1') est maintenue par un support (20).

7. Plaque de phase selon la revendication 6,
**caractérisée en ce que**
l'électrode (1') dépasse sur l'extrémité avant du support (20).

8. Plaque de phase selon la revendication 6 ou 7,
**caractérisée en ce que**
la section transversale du support (20) s'amincit de l'extérieur vers l'intérieur.

9. Plaque de phase selon une des revendications 1 à 8,
**caractérisée en ce que**
l'électrode (1') est équipée d'un mécanisme d'ajustement (24), au moyen de laquelle l'extrémité (9) du conducteur blindé (7) peut être ajustée par rapport à la portée du faisceau zéro (4).

10. Plaque de phase selon une des revendications 1 à 8,
**caractérisée en ce que**
un dispositif de déviation de faisceau (25) est disposé en amont de l'électrode (1') dans la direction du faisceau, au moyen duquel le faisceau zéro (4) peut être dévié de telle sorte qu'il puisse se positionner relativement au champ électrique (6).

11. Procédé de génération d'image, dans lequel une image générée électro-optiquement, dans laquelle des informations d'image ont été perdues en raison d'une projection d'ombre partielle du trajet de faisceau des faisceaux (5, 5') diffractés, est reconstruite en affectant les informations d'image identiques aux informations d'image perdues, symétriquement en vis-à-vis par rapport au faisceau zéro (4), **caractérisé en ce que** une reconstruction complète de l'image a lieu en employant une plaque de phase (1) située en totalité sur un côté du faisceau zéro (4), qui sert à générer un déphasage de ce dernier.

12. Procédé de génération d'image selon la revendication 11,
**caractérisé en ce que**
le contraste d'image est détecté et **en ce que** le champ électrique (6) est modifié en ce qui concerne son intensité et/ou son positionnement relativement au faisceau zéro (4) jusqu'à l'obtention d'un contraste d'image optimal.

13. Procédé de génération d'image selon la revendication 11 ou 12,
**caractérisé en ce que**
la plaque de phase (1) est positionnée avec son extrémité génératrice de champ (9) de manière à optimiser le déphasage relativement au faisceau zéro (4).

14. Procédé de génération d'image selon la revendication 11 ou 12,
**caractérisé en ce que**
le faisceau zéro (4) pour optimiser le déphasage relativement au champ (6) est positionné par déviation.

15. Microscope électronique (12), dans lequel sur un objet (2) le faisceau d' électrons (3) est scindé en un faisceau zéro (4) et des faisceaux d'électrons diffractés (5, 5'), comportant une plaque de phase (1), qui est disposée dans le plan focal objectif (15) du faisceau zéro (4), dans lequel la plaque de phase (1) est conçue comme une électrode (1'), afin de provoquer un déphasage du faisceau zéro (4) au moyen d'un champ électrique (6) généré par une tension, afin de produire une image riche en contraste du fait de l'interférence de ce dernier avec les rayons d'électrons diffractés (5, 5'),
**caractérisé en ce que**
l'électrode (1') est réalisée comme un conducteur blindé (7), qui s'étend à partir d'une fixation (8) essentiellement radialement dans la direction de la portée du faisceau zéro (4), dans lequel le conducteur blindé (7) présente une extrémité (9) avant la portée du faisceau zéro (4), de telle sorte qu'un champ (6) formé entre le blindage (10) et le conducteur (7) détecte cette portée.

16. Microscope électronique selon la revendication 15, **caractérisé en ce que**
il est équipé d'un dispositif de génération d'image, qui est conçu de telle sorte qu'une image générée électro-optiquement, dans laquelle des informations d'image ont été perdues en raison d'une projection d'ombre partielle du trajet de faisceau à travers la plaque de phase (1), est détectée au moyen d'un dispositif de détecteur (17) et reconstruit de telle sorte que les informations d'image identiques aux informations d'image perdues, symétriquement en vis-à-vis par rapport au faisceau zéro (4) soient affectées, dans lequel la reconstruction a lieu sans vides, puisque la plaque de phase (1) repose en totalité sur un côté du faisceau zéro (4).

17. Microscope électronique selon la revendication 15 ou 16,
**caractérisé en ce que**
il présente un mécanisme d'ajustement (24) pour l'électrode (1'), au moyen duquel l'extrémité (9) du conducteur blindé (7) peut être ajusté par rapport à la portée du faisceau zéro (4).

18. Microscope électronique selon la revendication 15 ou 16,
**caractérisé en ce que**
il présente un dispositif de déviation de faisceau (25) disposé en amont de l'électrode (1'), au moyen duquel le faisceau zéro (4) peut être dévié de telle sorte qu'il puisse être positionné relativement au champ électrique (6).

19. Microscope électronique selon es revendications 15 à 18,
**caractérisé en ce que**
un dispositif de détecteur (17') ainsi qu'un dispositif de régulation et d'évaluation d'image sont prévus, au moyen desquels le contraste d'image est détecté et la tension pour générer le champ électrique (6) est régulée ainsi que le positionnement de l'extrémité (9)à du conducteur blindé (7) relativement au faisceau zéro (4) est entrepris au moyen du mécanisme d'ajustement (24) et/ou le positionnement du faisceau zéro (4) par rapport à l'extrémité (9) du conducteur blindé (7) est entreprise au moyen du dispositif de déviation de faisceau (25), jusqu'à l'obtention d'un contraste d'image optimal.
